# EUROPÄISCHE PATENTSCHRIFT

(11) **EP 1 328 695 B1**
(45) Veröffentlichungstag und Bekanntmachung des Hinweises auf die Patenterteilung: **11.10.2006**
(21) Anmeldenummer: 01987836.2
(22) Anmeldetag: 11.10.2001
(51) Int. Cl.: E05B 65/20, H03K 17/96

(54) **VORRICHTUNG ZUM EINLEITEN EINES ÖFFNUNGS- UND VERRIEGELUNGSVORGANGS EINES KRAFTFAHRZEUGS**
DEVICE FOR INITIATING AN OPENING AND CLOSING PROCESS IN A MOTOR VEHICLE
DISPOSITIF POUR L'INITIALISATION D'UN PROCESSUS D'OUVERTURE ET DE VERROUILLAGE D'UN VEHICULE AUTOMOBILE

(30) Priorität: 14.10.2000 DE 10051055
(43) Veröffentlichungstag der Anmeldung: 23.07.2003
(73) Patentinhaber: ROBERT BOSCH GMBH, 70442 Stuttgart (DE)
(72) Erfinder: PANG, Peter, 71469 Stuttgart (DE); SCHAEFFNER, Daniel, 71282 Hemmingen (DE); GIEHLER, Elmar, 70499 Stuttgart-Hausen (DE)
(86) Internationale Anmeldenummer: PCT/DE2001/003907
(87) Internationale Veröffentlichungsnummer: WO 2002/033203

(56) Entgegenhaltungen:
- EP-A- 0 218 251
- EP-A- 0 954 098
- WO-A-01/40606
- WO-A-97/41322
- DE-A- 19 620 059
- DE-C- 19 805 659

## Beschreibung

### Stand der Technik

Die Erfindung geht aus von einer Vorrichtung zum Einleiten eines Öffnungs- und Verriegelungsvorgangs eines Kraftfahrzeugs nach der Gattung des unabhängigen Anspruchs. Aus der EP-A-954 098 ist bereits ein Erkennungssystem bekannt, das die Nähe einer Person in Abhängigkeit von einer Kapazitätsänderung einer im Türgriff angeordneten Einheit feststellt. Weiterhin ist ein Schalter vorgesehen, den der Benutzer im Falle einer nicht registrierten Kapazitätsänderung betätigen kann, um einen Abfragevorgang mit einem Berechtigungsmittel zur Erlangung der Zugangsberechtigung in Gang zu setzen.

Aus der WO 97/41322 ist es darüber hinaus bekannt, in den Handhaben der Türgriffe eines Fahrzeugs wenigstens einen kapazitiven Sensor anzubringen, der je eine Elektrode in der Handhabe und eine Gegenelektrode in dem der Handhabe gegenüber liegenden Teil der Türe aufweist. Wird zwischen beiden Elektroden ein elektrisches Feld aufgebaut, so kann dieses dazu benutzt werden, bereits den Zutrittswunsch einer nach einem Türgriff greifenden Person während einer Annäherung ihrer Hand zu sensieren. Zusätzlich ist vorgesehen, in der Außenschale der Handhabe einen zweiten Sensor einzusetzen, der den Wunsch einer Person nach einem Sichern des Fahrzeugs sensiert.

Der Erfindung liegt die Aufgabe zugrunde, eine baulich vereinfachte Anordnung anzugeben, mit der sowohl eine Verriegelung wie auch eine Entriegelung des Kraftfahrzeugs erreicht werden kann und die eine eindeutige Zuordnung der gewünschten Aktivierungshandlung gewährleistet. Diese Aufgabe wird durch die Merkmale des unabhängigen Anspruchs gelöst.

### Vorteile der Erfindung

Die erfindungsgemäße Vorrichtung zum Einleiten eines Öffnungs- und Verriegelungsvorgangs eines Kraftfahrzeugs umumfasst eine erste Annäherungssensorik, die ein Entriegelungswunschsignal zur Einleitung eines Öffnungsvorgangs eines Schließsystems eines Kraftfahrzeugs erzeugt, wenn sich ein Benutzer der ersten Annäherungssensorik nähert, und eine zweite Annäherungssensorik, die ein Verriegelungswunschsignal zur Einleitung eines Verriegelungsvorgangs des Schließsystems erzeugt, wenn sich ein Benutzer der zweiten Annäherungssensorik nähert, wobei die erste und die zweite Annäherungssensorik zumindest eine erste bzw. eine zweite Elektrode umfassen zur Erkennung einer Annäherung über eine Kapazitätsauswertung. Zur Abschirmung ist eine mit einem Bezugspotential verbundene Bezugspotentialelektrode vorgesehen, die zwischen erster und zweiter Elektrode angeordnet ist. Da somit in vorteilhafter Weise das Feld jeder Elektrode durch die Bezugspotentialelektrode gestoppt wird, so dass das Feld der einen Elektrode von einer Annäherung auf die jeweils andere Seite nicht beeinflusst wird, erleichtert dies eine eindeutige Zuordnung der gewünschten Aktivierungshandlung. Die Verwendung zweier Annaherungssensoren ermöglicht zudem einerseits eine genaue Unterscheidung, ob der Benutzer einen öffnungs- oder einen Verriegelungsvorgang des Kraftfahrzeugs einleiten möchte. Eine bewegliche Membran wie bei einem Taster zum Einleiten eines Öffnungs- oder Verriegelungsvorgangs ist nicht mehr erforderlich. Der Verzicht auf vom Benutzer zu betätigende Schaltmittel verringert einen möglichen Angriffspunkt für Vandalismus. Bei einem nicht mechanisch zu betätigenden Teil erhöht sich wegen abnutzungsfreier Kontakte die Lebensdauer der Gesamtanordnung. Ausserdem kann die Annäherungssensorik komplett in den Türgriff integriert werden, so dass nicht mehr die mechanische Betätigbarkeit der Anordnung im Vordergrund steht. Sind die beiden Annäherungssensoren im Türaussengriff integriert, kann dieser sehr einfach gefertigt werden. Auch die Toleranzproblematik, wie sie bei einem Einbau eines Schließtasters in den Türaussengriff auftritt, entfällt. Der Verzicht auf vom Benutzer zu betätigende Taster ermöglicht auch das komplette Überlackieren des Türaussengriffs und erhöht damit die Freiheitsgrade des Designs.

In einer zweckmäßigen Weiterbildung ist die erste Annäherungssensorik auf der dem Kraftfahrzeug zugewandten Türgriffsseite angeordnet. Möchte der Benutzer das Kraftfahrzeug entriegeln, so greift er die dem Kraftfahrzeug zugewandte Türgriffseite, um die Kraftfahrzeugtüre zu öffnen. Dadurch wird sicher der Annäherungsvorgang des Benutzers erkannt zur Auslösung des Öffnungsvorgangs des Schließsystems.

In einer zweckmäßigen Weiterbildung ist vorgesehen, die zweite Annäherungssensorik auf der dem Kraftfahrzeug abgewandten Türgriffseite anzuordnen. Die Türgriffaussenseite berührt der Benutzer in der Regel mit dem Schliessen der Fahrzeugtür. Die zweite Annäherungssensorik erkennt somit eine Annäherung in Übereinstimmung mit dem Bedienvorgang in zuverlässiger Art und Weise zur Auslösung eines Verriegelungsvorgangs.

Vorzugsweise sind die Elektrode der ersten Annäherungssensorik, die Elektrode der zweiten Annäherungssensorik, die Auswerteeinheit der ersten und/oder der zweiten Annäherungssensorik sowie zumindest eine Spannungsversorgung zumindest einer Auswerteeinheit in einem Gehäuse zu einer Baueinheit zusammengefasst. Diese Baueinheit kann leicht in dem Türgriff angeordnet werden. Alternativ könnte die die Batteriespannung aufbereitende spannungsversorgung im Kraftfahrzeuginnenraum angeordnet sein.

Weitere zweckmaßige weiterbildungen ergeben sich aus weiteren abhängigen Ansprüchen und aus der Beschreibung.

### Zeichnung

Ein Ausführungsbeispiel ist in der Zeichnung dargestellt und wird im folgenden näher beschrieben.

Es zeigen die Figur 1 ein Blockschaltbild einer Elektronikbaugruppe, die Figur 2 die in einem Turaussengriff angeordnete Elektronikbaugruppe, die Figur 3 die einzelnen Komponenten der Elektronikbaugruppe mit Blickrichtung auf die vom Kraftfahrzeug abgewandte Türgriffseite, die Figur 4 die Komponenten der Elektronikbaugruppe in Blickrichtung von der Seite des Kraftfahrzeugs aus, die Figur 5 eine schematische Darstellung der Gesamtanordnung des Schließsystems, die Figur 6 eine weitere mögliche Elektrodenanordnung, die Figur 7 ein alternatives Ausführungsbeispiel, die Figur 8 eine weitere Anordnungsmöglichkeit der Elektroden im Türgriff, die Figuren 9 und 10 zwei Ausführungsbeispiele mit einer zwischen den beiden Elektroden angeordneten Masseelektrode sowie die Figur 11 ein Ablaufdiagramm.

### Beschreibung der Ausführungsbeispiele

Eine Elektronikbaugruppe 10 umfasst zumindest eine erste Elektrode 11, deren Ausgangssignal einer ersten Auswerteeinheit 14 zugeführt ist. Die erste Auswerteeinheit 14 erzeugt ein Entriegelungswunschsignal 20. Eine zweite Auswerteeinheit 16 erfasst das Ausgangssignal der zweiten Elektrode 12 und setzt es in ein Schließwunschsignal 22 um. Der Elektronikbaugruppe 10 sind eine Versorgungsspannung 24 sowie ein Bezugspotential 26 zugeführt. Ein Spannungsregler 18 setzt die Versorgungsspannung 24 in eine interne Versorgungsspannung für die erste Auswerteeinheit 14 und für die zweite Auswerteeinheit 16 um.

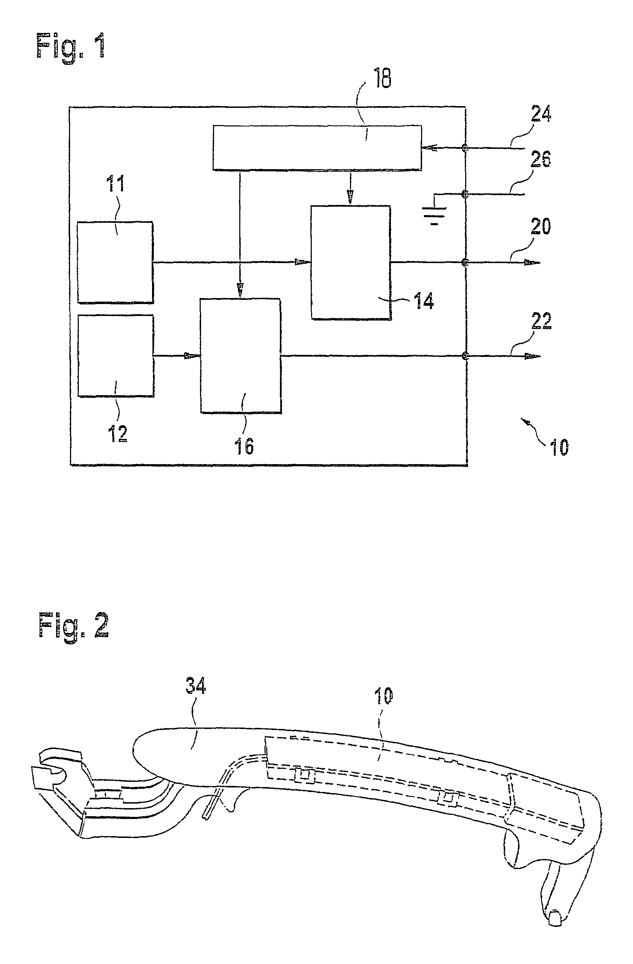

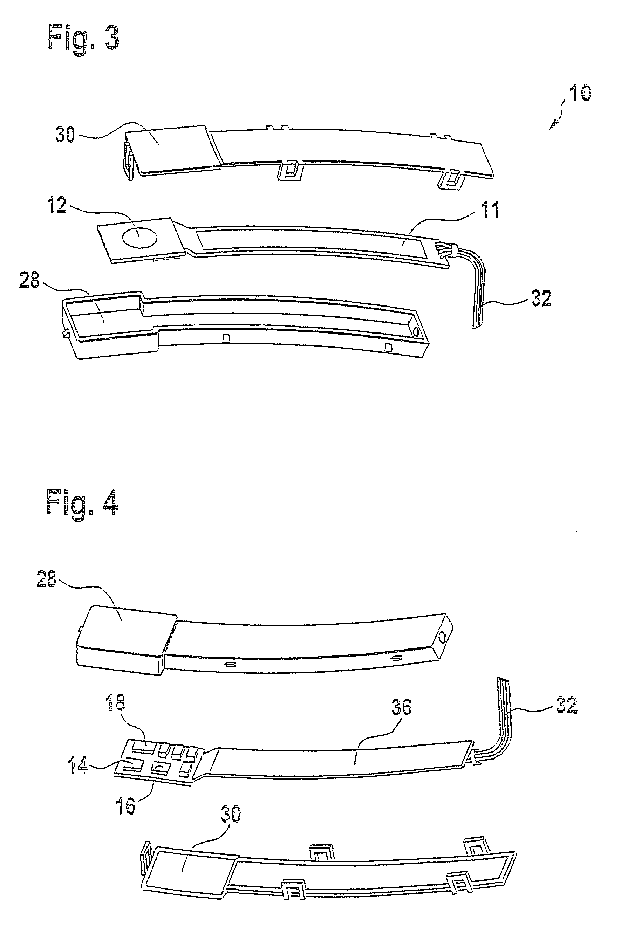

Die Figur 2 zeigt einen Türaussengriff 34, in dem die Elektronikbaugruppe 10 integriert ist. Gemäß Figur 3 besteht die Elektronikbaugruppe 10 aus der zweiten Elektrode 12, die kreisförmig ausgeprägt ist, und einer rechteckig ausgeführten ersten Elektrode 11. Die erste Elektrode 11 und die zweite Elektrode 12 sind zueinander auf unterschiedlichem Höhenniveau angeordnet, so dass die erste Elektrode 11 in der Nähe der Türgriffinnenseite, die zweite Elektrode 12 jedoch in der Nähe der Türgriffaussenseite im montierten Zustand angeordnet ist. Zur Weiterleitung des Entriegelungswunschsignals 20 und des Schließwunschsignals 22 sowie zur Zuführung der Versorgungsspannung 24 wie auch des Bezugspotentials 26 ist ein Anschlusskabel 32 vorgesehen. Die beiden Elektroden 11, 12 werden von einem Gehäuse umschlossen, das aus einem Gehäuseoberteil 30 und einem Gehäuseunterteil 28 gebildet wird.

Bei der Ansicht gemäß Figur 4 ist zu sehen, dass die erste Auswerteeinheit 14, die zweite Auswerteeinheit 16 sowie der Spannungsregler 18 auf einer der zweiten Elektrode 12 gegenüberliegenden Seite angeordnet sind. Wiederum sind das Gehäuseoberteil 30 wie auch das Gehäuseunterteil 28 aus einer der Figur 3 entgegengesetzten Perspektive zu sehen.

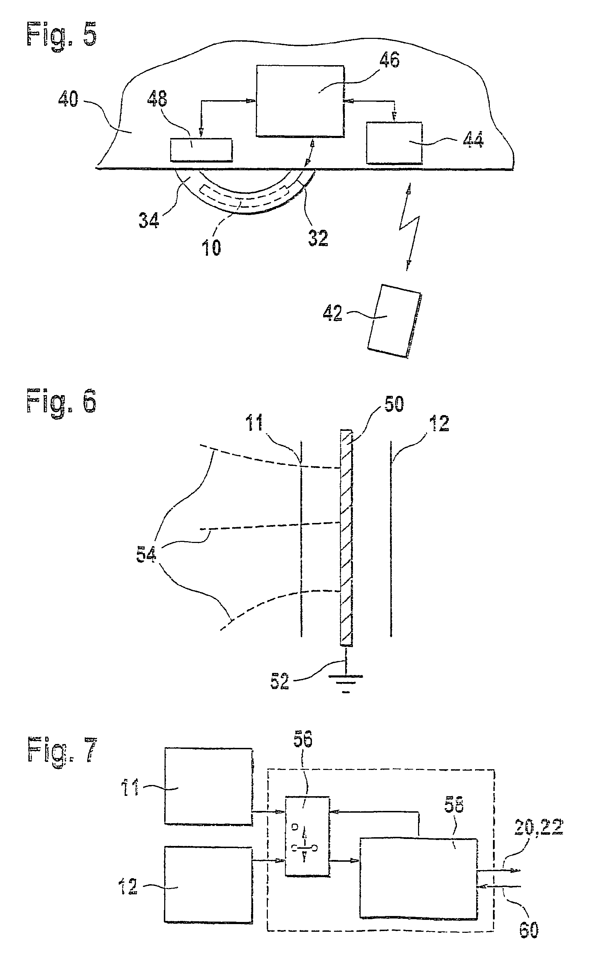

Der Figur 5 läßt sich die schematische Darstellung einer Gesamtanordnung entnehmen. So ist die Elektronikbaugruppe 10 in dem Türaussengriff 34 integriert. Über das Anschlusskabel 32 steht die Elektronikbaugruppe 10 mit einem Steuergerät 46 in Verbindung. Im Innenraum des Kraftfahrzeugs 40 ist ein Sender/Empfänger 44 angeordnet, der mit einem von einem Benutzer mitführbaren Transponder 42 Berechtigungsdaten austauscht. Das Steuergerat 46 steuert eine Schließvorrichtung 48 des Kraftfahrzeugs 40 an und enthält gegebenenfalls entsprechende Rückmeldesignale über den Zustand der Schließvorrichtung 48.

Gemäß Figur 6 ist zwischen erster und zweiter Elektrode 11, 12 eine Masseelektrode 50 angeordnet, die mit Masse 52 als Bezugspotential verbunden ist. Die Masselektrode 50 schirmt das anhand der Feldlinien 54 dargestellte Feld der ersten Elektrode 11 von der zweiten Elektrode 12 ab.

Bei dem Ausführungsbeispiel gemäß Figur 7 werden die Ausgangssignale der ersten und zweiten Elektrode 11, 12 einem Umschaltmittel 56 zugeführt, das lediglich eines der beiden an eine Auswerteeinheit 58 weiterleitet. Die Auswerteeinheit 58 steuert das Umschaltmittel 56 in Abhängigkeit von einem Eingangssignal 60 an. Die Auswerteeinheit 58 erzeugt ein Entriegelungswunschsignal 20 oder ein Schließwunschsignal 22.

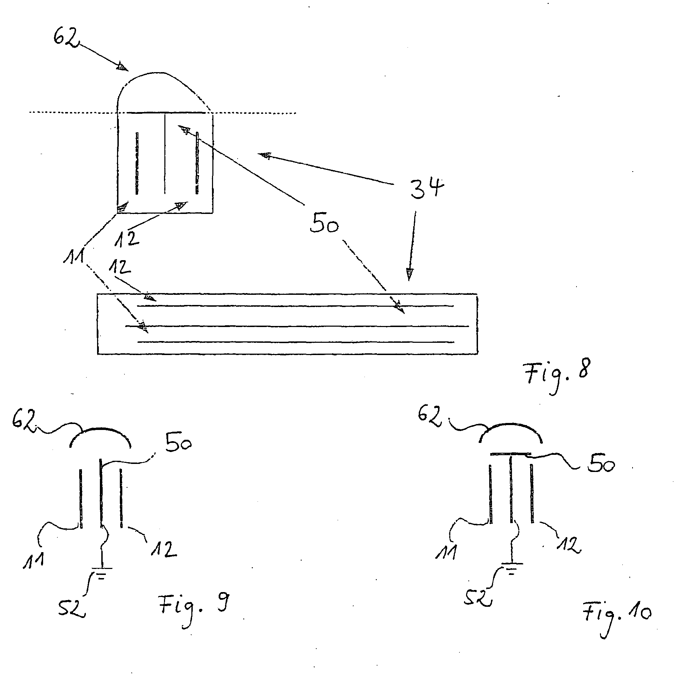

Bei dem Ausführungsbeispiel gemäß Figur 8 ist zur eindeutigen Trennung und gegenseitigen Abschirmung der Sensorsignale von erster und zweiter Elektrode 11, 12 zwischen beiden Elektroden 11, 12 eine Masseelektrode 50 angeordnet. Der Querschnitt der Masseelektrode 50 ist T-förmig ausgestaltet in der Weise, dass der Querteil der Masseelektrode 50 zwischen einer metallischen Zierkappe 62 oder Zierbeschichtung des Türgriffs 34 und den beiden Elektroden 11, 12 liegt und der Abschirmung dient. Auch ein Übersprechen zwischen den beiden Sensoren 11, 12 wird dadurch verhindert.

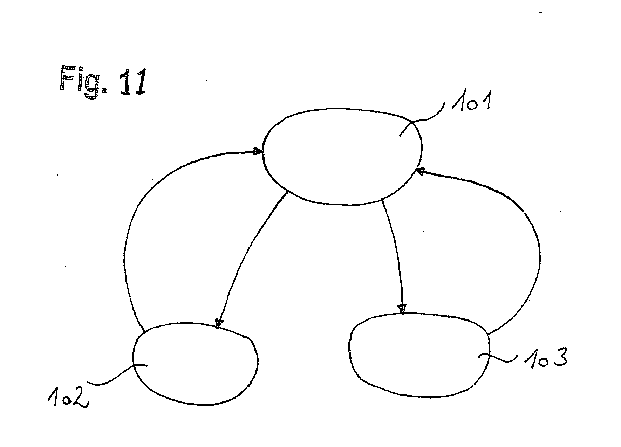

Gemäß Figur 9 ist die obere Anordnung der Figur 8 nun so verändert, dass die Zierkappe 62 oder die metallische Zierbeschichtung genauso wie die Masseelektrode 50 elektrisch leitend mit Masse 52 kontakiert ist. Diese Maßnahme verbessert die Trennung der Erkennungsbereiche der beiden Elektroden 11, 12.

Der in Figur 10 gewählte Aufbau entspricht im wesentlichen dem der Figur 8. Wiederum wird die T-förmige Masselektrode 52 auch zur Abschirmung der beiden Elektorden 11, 12 gegeneinander und gegenüber der Zierkappe 62 verwendet.

Als Annäherungssensorik kommen nachfolgend kapazitive Sensoren zum Einsatz. Dabei sind die beiden Elektroden 11, 12 jeweils Teile einer Anordnung, deren Kapazität sich bei der Annäherung eines Benutzers signifikant ändert. Überschreitet die Kapazitätsänderung einen bestimmten Grenzwert, so wird auf einen anwesenden Benutzer geschlossen. Hierzu sind die jeweiligen Auswerteeinheiten 14, 16 vorgesehen. Die erste Elektrode 11 ist vorzugsweise in der dem Kraftfahrzeug 40 zugewandten Seite des Türaussengriffs 34 angeordnet.

Der Benutzer möchte nun den Türgriff 34 im Sinne eines Öffnens betätigen. Die sich nähernde Hand des Benutzers bewirkt eine Kapazitätsänderung der die erste Elektrode 11 umfassenden Anordnung. Sofern die Kapazitätsänderung einen bestimmten Grenzwert überschreitet, erzeugt die erste Auswerteeinheit 14 ein Entriegelungswunschsignal 20, welches über das Anschlusskabel 32 an das Steuergerät 46 weitergeleitet wird. Daraufhin leitet das Steuergerät 46 eine Berechtigungsabfrage ein. Ein Benutzer muß sich anhand eines mitgeführten Transponders 42 als berechtigt ausweisen. Hierbei sendet der Sender 44 ein Fragesignal an den Transponder 42, der daraus ein Antwortsignal berechnet und an den Empfanger 44 zurücksendet. Stimmt das von dem Transponder 42 zuruckgesendete Antwortsignal mit einem von dem Steuergerät 46 berechneten Antwortsignal überein, so wird auf einen berechtigten Benutzer geschlossen. Das Steuergerät 46 erzeugt einen Öffnungsbefehl für die Schließvorrichtung 48. Das Kraftfahrzeug 40 wird entriegelt. Stimmt jedoch das erwartete Antwortsignal mit dem empfangenen Antwortsignal nicht überein, so erhält der Benutzer keine Zugangsberechtigung zu dem Kraftfahrzeug 40. Die Schließvorrichtung 48 verbleibt im verriegelten Zustand.

Nähert sich der Benutzer der zweiten Elektrode 12, um einen Schließvorgang des Kraftfahrzeugs 40 einzuleiten, erkennt die zweite Auswerteeinheit 16 anhand der Kapazitätsänderung einen sich in der Nähe der zweiten Elektrode 12 befindlichen Benutzer. Daraufhin wird ein Schließwunschsignal 22 erzeugt und über das Anschlusskabel 32 an das Steuergerät 46 weitergeleitet. Entweder wiederholt das Steuergerät 46 die Berechtigungsprozedur, wie sie bei dem Entriegeln des Kraftfahrzeugs 40 entlaufen wurde, oder aber ein Schließbefehl wird sofort an die Schließvorrichtung 48 weitergegeben.

Sollten die Auswerteeinheiten 14, 16 sowohl ein Entriegelswunschsignal 20 als auch ein Schließwunschsignal 22 generiert haben, so wertet das Steuergerät 46 nur das Signal aus, welches zu einer Veränderung des Schließzustand der Schließvorrichtung 48 führen würde. Der Zustand der Schließvorrichtung 48 ist über die entsprechenden Rückmeldesignale der Schließvorrichtung 48 dem Steuergerät 46 bekannt. So würde bei einem verriegelten Kraftfahrzeug 40 nur das Entriegelungswunschsignal 20 zu einer entsprechenden Ansteuerung führen, nicht hingegen das Auftreten eines Schließwunschsignals 22.

Bei dem Ausführungsbeispiel gemäß Figur 1 ist nun ein Spannungsregler 18 vorgesehen, der aus der Batteriespannung, das heißt der Versorgungsspannung 24, eine die beiden Auswerteeinheiten 14, 16 versorgende interne Spannung von beispielsweise 5 V generiert. Es könnte auch für jede der Auswerteeinheiten 14, 16 separate Spannungsregler 18 vorgesehen sein, die jeweils unabhängig voneinander aktivierbar sind. Ein den Spannungsrelger 18 aktivierendes oder deaktivierendes Steuersignal konnte über ein zusatzliches Kabel oder codiert auf einem bereits vorhandenen Kabel, beispielsweise das der Versorgungsspannung 24, übertragen werden.

Die beiden Auswerteeinheiten 14, 16 konnen sich hinsichtlich ihres Ruhestrombedarfs, bezüglich ihrer Empfindlichkeit oder der Ansprechgeschwindikeit unterscheiden, um so eine Anpassung an die jeweilige Situation (Öffnen, Schliessen) zu erreichen. Insbesondere kann vorgesehen sein, in Abhängigkeit von dem Zustand der Schließvorrichtung 48 die jeweilige Auswerteeinheit 14, 16 zu aktivieren oder zu deaktivieren beziehungsweise in einen Ruhebetrieb zu versetzen. Ist das Kraftfahrzeug 40 beispielsweise verriegelt, so ist lediglich mit einem Entriegelungswunsch zu rechnen, der nur über die erste Elektrode 11 ausgelöst werden kann. Somit kann die zweite Auswerteeinheit, die lediglich zur Erzeugung eines Schließwunschsignals 22 zum Verriegeln des Kraftfahrzeugs 40 führen könnte, deaktiviert werden. Die zweite Auswerteeinheit 16 könnte beispielsweise nur dann aktiviert werden, wenn nach dem Deaktivieren des Kraftfahrzeugs 40 ein Öffnen und ein Schliessen der Fahrertür vorausgegangen sind. Dadurch kann der Ruhestrombedarf der Gesamtanordnung reduziert werden.

Die erste Elektrode 11 ist vorzugsweise rechteckförmig ausgeführt, um im wesentlichen mit der erwarteten Grifffläche der Hand des Benutzers übereinzustimmen. Die zweite Elektrode 12 zum Erkennen eines Schließwunschs, ist kreisförmig oder ellipsenförmig ausgebildet, und insbesondere so dimensioniert, dass sie das Nähern eines Fingers, beispielsweise des Daumens, sicher detektiert. Somit tragen unterschiedliche Elektrodenformen den jeweils unterschiedlichen Bedienvorgängen Rechnung. Als Elektroden 11, 12 werden beispielsweise Leiterbahnen der Elektronikbaugruppe 10 eingesetzt. Die Leiterplatte 36, auf der die Elektroden 11, 12 sowie die beiden Auswerteeinheiten 14, 16 und der Spannungsregler 18 angeordnet sind, wird von einem Gehäuse umschlossen, das aus Gehäuseoberteil 30 und Gehäuseunterteil 28 besteht. Über eine Ausnehmung wird das Anschlusskabel 32 zum Kraftfahrzeuginnenraum geführt.

Bei dem Ausführungsbeispiel gemäß Figur 6 sind die beiden Elektroden 11, 12 durch eine zwischen den beiden Elektroden 11, 12 eingebrachte Masseelektrode 50 funktional getrennt. So gelangt das der ersten Elektrode 11 zugeordnete Feld, verdeutlicht anhand der Feldlinien 54, nicht weiter als zu der Masseelektrode 50, so dass die zweite Elektrode 12 kein Feld detektiert, das durch die Annäherung eines Benutzers an die erste Elektrode 11 beeinflusst wurde. Die Trennung der beiden Elektroden 11, 12 voneinander könnte beispielsweise durch eine sogenannte mehrlagige Leiterplatte 36 realisiert werden.

In einer alternativen Ausgestaltung gemäß Figur 7 ist lediglich eine Auswerteeinheit 58 für die beiden Elektroden 11, 12 vorgesehen. Das Umschaltmittel 56 stellt sicher, dass entweder das Ausgangssignal der ersten Elektrode 11 oder das Ausgangssignal der zweiten Elektrode 12 der Auswerteeinheit 58 zur Verfügung gestellt wird. Das Umschaltmittel 56 ist so angesteuert, dass immer das Ausgangssignal derjenigen Elektrode 11, 12 ausgewertet wird, deren Annäherungserkennung zu einer Veränderung des Zustandes des Schließsystems 48 führen würde. Im verriegelten Zustand leitet das Umschaltmittel 56 das Ausgangssignal der ersten Elektrode 11, im entriegelten Zustand das der zweiten Elektrode 12 weiter. Die entsprechende Information des Verriegelungszustandes des Schließsystems 48 gelangt über das Eingangssignal 60 an die Auswerteeinheit 58, die es in die entsprechende Ansteuerung des Umschaltmittels 56 umsetzt. Umschaltmittel 56 und Auswerteeinheit 58 konnten zu einer Baueinheit zusammengefaßt sein. Die Ansteuerung des Umschaltmittels 56 konnte auch direkt durch das Eingangssignal 60 bewirkt werden. Dank der beschriebenen Anordnung kann der Bauteileaufwand weiter reduziert werden.

Die Ausführungsbeispiele der Figuren 8 bis 10 stellen eine verbesserte Entkopplung der ersten und zweiten Elektrode 11, 12 auch bei räumlich engem Aufbau der Sensorelektroden 11, 12 sicher. Insbesondere werden hierbei auch Störeinflüsse von Designelementen am Türgriff 34 wie beispielsweise elektrisch leitende Chromblenden, Chromdeckel oder Zierbeschichtungen verringert. Auch ein Übersprechen zwischen den beiden Elektroden 11, 12 kann verhindert werden, indem die beiden Elektroden 11, 12 aufeinander abgestimmt abgefragt werden. Dies wird erfindungsgemäß dadurch erreicht, dass zwischen erster und zweiter Elektrode 11, 12 eine mit Masse 52 als mögliches Bezugspotential verbundene Masseelektrode 50 angeordnet ist. Um die Störeinflüsse gegenüber elektrisch leitenden Designelementen 62 des Türgriffs 34 zu minimieren, ist die Masseelektrode 50 auch zwischen diesen Designelementen 62 und den beiden Elektroden 11, 12 angeordnet. Auch können die Designelemente 62 selbst elektrisch leitend mit Masse 52 verbunden sein.

Trotz Feldformung und Entkopplung besteht beim Umfassen des Griffes 34 noch eine gewisse Gefahr, dass beide Sensoren bzw. Elektroden 11, 12 auslösen. Durch die Anordnung und Entkopplung wird jedoch der Sensor 11, 12, der ein dem Bedienwunsch entsprechendes Signal auslöst, zuerst aktiviert werden. Um Probleme bei der Auswertung zu vermeiden, kann eine Logik implementiert sein, die nur das erste Signal passieren läßt und das zweite Signal dann sperrt. Sinnvollerweise wird die Sperrung erst wieder aufgehoben, wenn beide Sensoren 11, 12 keine Annäherung mehr registrieren. Das zugehörige Ablaufdiagramm ist in Figur 11 dargestellt. In Zustand 101 befindet sich das System im Ruhezustand. Es wechselt in den Zustand 102, wenn die erste Elektrode 11 ein Öffnungssignal abgegeben hat. Im Zustand 102 wird das Entrieglungswunschsignal 20 ausgegeben. Ein Wechsel in den Ruhezustand 101 erfolgt nur dann, wenn die Sensoren 11, 12 kein Öffnungssignal und kein Schließsignal abgeben. Der Zustand 103 wird vom Ruhezustand 101 aus nur dann erreicht, wenn ein Schließsignal erkannt wird. Im Zustand 103 wird das Schließwunschsignal 22 ausgegeben. Der Wechsel in den Ruhezustand 101 erfolgt nur dann, wenn kein Schließsignal und kein Öffnungssignal erkannt werden. Diese Verarbeitung konnte auch in dem fahrzeugseitigen Steuergerat durchgefuhrt werden.

Die Elektroden 11, 12 können Bestandteil einer Mehrlagenplatine sein, die beispielsweise auch die Auswerteeinheiten 14, 16 enthält.

## Patentansprüche

1. Vorrichtung zum Einleiten eines Öffnungs- und Verriegelungsvorgangs eines Kraftfahrzeugs, mit einer ersten Annäherungssensorik (11, 14), die ein Entriegelungswunschsignal (20) zur Einleitung eines Öffnungsvorgangs eines Schließsystems (46, 48) eines Kraftfahrzeugs (40) erzeugt, wenn sich ein Benutzer der ersten Annäherungssensorik (11, 14) nähert, und mit einer zweiten Annäherungssensorik (12, 16), die ein Schließwunschsignal (22) zur Einleitung eines Verriegelungsvorgangs des Schließsystems (46, 48) des Kraftfahrzeugs (40) erzeugt, wenn sich ein Benutzer der zweiten Annäherungssensorik (12, 16) nähert, wobei die erste und die zweite Annäherungssensorik (11, 14, 12, 16) zumindest eine erste bzw. eine zweite Elektrode (11, 12) umfassen zur Erkennung einer Annäherung über eine Kapazitätsauswertung, **dadurch gekennzeichnet, dass** zur Abschirmung eine mit einem Bezugspotential (52) verbundene Bezugspotentialelektrode (50) vorgesehen ist, die zwischen erster und zweiter Elektrode (11, 12) angeordnet ist.

2. Vorrichtung nach Anspruch 1, **dadurch gekennzeichnet, dass** die erste und/oder zweite Annäherungssensorik (11, 14, 12, 16) in einem Türaussengriff (34) angeordnet ist.

3. Vorrichtung nach einem der vorhergehenden Ansprüche, **dadurch gekennzeichnet, dass** die erste Annäherungssensorik (11, 14) an der dem Kraftfahrzeug (40) zugewandten Seite des Türaussengriffs (34) angeordnet ist.

4. Vorrichtung nach einem der vorhergehenden Ansprüche, **dadurch gekennzeichnet, dass** die zweite Annäherungssensorik (12, 16) an der dem Kraftfahrzeug (40) abgewandten Seite des Türaussengriffs (34) angeordnet ist.

5. Vorrichtung nach einem der vorhergehenden Ansprüche, **dadurch gekennzeichnet, dass** die erste und zweite Annäherungssensorik (11, 14, 12, 16) auf einer gemeinsamen Leiterplatte angeordnet sind.

6. Vorrichtung nach einem der vorhergehenden Ansprüche, **dadurch gekennzeichnet, dass** eine spannungsversorgung (18) vorgesehen ist zur Versorgung der ersten und/oder zweiten Auswerteeinheit (14, 16).

7. Vorrichtung nach einem der vorhergehenden Ansprüche, **dadurch gekennzeichnet, dass** die erste und zweite Elektrode (11, 12), die erste und/oder zweite Auswerteeinheit (14, 16) und die Spannungsversorgung (18) in einem Gehäuse (28, 30) angeordnet sind.

8. Vorrichtung nach einem der vorhergehenden Ansprüche, **dadurch gekennzeichnet, dass** mit Auftreten des Entriegelungswunschsignals (20) und/oder des Schließwunschsignals (22) eine Berechtigungsabfrage mit einem vom Benutzer mitgeführten Transponder (42) gestartet ist.

9. Vorrichtung nach einem der vorhergehenden Ansprüche, **dadurch gekennzeichnet, dass** die Auswertung des Signals der ersten Elektrode (11) und/oder die Erzeugung eines Entriegelungswunschsignals (22) nur erfolgt, wenn sich das Schließsystem (48) im verriegelten Zustand befindet.

10. Vorrichtung nach einem der vorhergehenden Ansprüche, **dadurch gekennzeichnet, dass** zumindest ein Umschaltmittel (56) vorgesehen ist, das entweder das Ausgangssignal der ersten Elektrode (11) oder das Ausgangssignal der zweiten Elektrode (12) an eine Auswerteeinheit (58) weiterleitet.

11. Vorrichtung nach einem der vorhergehenden Ansprüche, **dadurch gekennzeichnet, dass** das Umschaltmittel (56) in Abhängigkeit von dem Zustand des Schließsystems (48) angesteuert ist.

12. Vorrichtung nach einem der vorhergehenden Ansprüche, **dadurch gekennzeichnet, dass** die Bezugspotentialelektrode (50) zwischen erster und/oder zweiter Elektrode (11, 12) und einer elelktrisch leitenden Schicht (62) des Türaussengriffs (34) angeordnet ist.

13. Vorrichtung nach einem der vorhergehenden Ansprüche, **dadurch gekennzeichnet, dass** erste und zweite Elektrode (11, 12) zeitversetzt gegeneinander angesteuert werden.

14. Vorrichtung nach einem der vorhergehenden Ansprüche, **dadurch gekennzeichnet, dass** bei der Auslösung der ersten und zweiten Elektrode (11, 12) nur das Signal der Elektrode (11, 12) weitergeleitet wird, das zuerst ausgelöst wurde.

15. Vorrichtung nach einem der vorhergehenden Ansprüche, **dadurch gekennzeichnet, dass** ein neues Signal der Elektrode (11, 12) nur weitergeleitet wird, wenn zuvor beide Elektroden (11, 12) keine Annäherung erkannt haben.

## Claims

1. Apparatus for initiating an opening and locking process of a motor vehicle, having a first proximity sensor system (11, 14) which generates an unlocking request signal (20) for initiating an opening process of a closing system (46, 48) of a motor vehicle (40) when a user approaches the first proximity sensor system (11, 14), and having a second proximity sensor system (12, 16) which generates a closing request signal (22) for initiating a locking process of the closing system (46, 48) of the motor vehicle (40) when a user approaches the second proximity sensor system (12, 16), with the first and second proximity sensor systems (11, 14, 12, 16) comprising at least a first and, respectively, a second electrode (11, 12) for detecting proximity by means of evaluating a capacitance, **characterized in that** a reference potential electrode (50) which is connected to a reference potential (52) is provided for screening purposes and is arranged between the first and second electrodes (11, 12).

2. Apparatus according to Claim 1, **characterized in that** the first and/or second proximity sensor systems or system (11, 14, 12, 16) is/are arranged in an external door handle (34).

3. Apparatus according to either of the preceding claims, **characterized in that** the first proximity sensor system (11, 14) is arranged on that side of the external door handle (34) which faces the motor vehicle (40).

4. Apparatus according to one of the preceding claims, **characterized in that** the second proximity sensor system (12, 16) is arranged on that side of the external door handle (34) which faces away from the motor vehicle (40).

5. Apparatus according to one of the preceding claims, **characterized in that** the first and second proximity sensor systems (11, 14, 12, 16) are arranged on a common printed circuit board.

6. Apparatus according to one of the preceding claims, **characterized in that** a power supply system (18) is provided for supplying power to the first and/or second evaluation units or unit (14, 16).

7. Apparatus according to one of the preceding claims, **characterized in that** the first and second electrodes (11, 12), the first and/or second evaluation units or unit (14, 16) and the power supply system (18) are arranged in a housing (28, 30).

8. Apparatus according to one of the preceding claims, **characterized in that** an authorization check with a transponder (42), which is carried by the user, is started when the unlocking request signal (20) and/or the closing request signal (22) occur/occurs.

9. Apparatus according to one of the preceding claims, **characterized in that** the signal from the first electrode (11) is evaluated and/or an unlocking request signal (22) is generated only when the closing system (48) is in the locked state.

10. Apparatus according to one of the preceding claims, **characterized in that** at least one switching means (56) is provided which transmits either the output signal from the first electrode (11) or the output signal from the second electrode (12) to an evaluation unit (58).

11. Apparatus according to one of the preceding claims, **characterized in that** the switching means (56) is actuated as a function of the state of the closing system (48).

12. Apparatus according to one of the preceding claims, **characterized in that** the reference potential electrode (50) is arranged between the first and/or second electrodes or electrode (11, 12) and an electrically conductive layer (62) of the external door handle (34).

13. Apparatus according to one of the preceding claims, **characterized in that** the first and second electrodes (11, 12) are actuated with a time delay with respect to one another.

14. Apparatus according to one of the preceding claims, **characterized in that** when the first and second electrodes (11, 12) are triggered only the signal from the electrode (11, 12) which was triggered first is transmitted.

15. Apparatus according to one of the preceding claims, **characterized in that** a new signal from the electrode (11, 12) is only transmitted when neither electrode (11, 12) has previously detected proximity.

## Revendications

1. Dispositif d'initialisation d'un processus d'ouverture et de verrouillage d'un véhicule automobile, comprenant un premier capteur d'approche (11, 14) qui génère un signal de demande de déverrouillage (20) pour initialiser un processus d'ouverture d'un système de fermeture (46, 48) d'un véhicule automobile (40) lorsqu'un utilisateur s'approche du premier capteur d'approche (11, 14), et un deuxième capteur d'approche (12, 16) qui génère un signal de demande de fermeture (22) pour initialiser un processus de verrouillage du système de fermeture (46, 48) du véhicule automobile (40) lorsqu'un utilisateur s'approche du deuxième capteur d'approche (12, 16), les premier et deuxième capteurs d'approche (11, 14, 12, 16) comprenant au moins une première ou une deuxième électrode (11, 12) pour reconnaître une approche par une exploitation capacitive,
**caractérisé en ce que**
pour le blindage, une électrode de potentiel de référence (50) reliée à un potentiel de référence (52) est disposée entre les première et deuxième électrodes (11, 12).

2. Dispositif selon la revendication 1,
**caractérisé en ce que**
le premier et/ou le deuxième capteur d'approche (11, 14, 12, 16) est (sont) dans une poignée de portière extérieure (34).

3. Dispositif selon l'une quelconque des revendications précédentes,
**caractérisé en ce que**
le premier capteur d'approche (11, 14) est sur la face de la poignée de portière extérieure (34) tournée vers le véhicule automobile (40).

4. Dispositif selon l'une quelconque des revendications précédentes,
**caractérisé en ce que**
le deuxième capteur d'approche (12, 16) est sur la face de la poignée de portière extérieure opposée au véhicule automobile (40).

5. Dispositif selon l'une quelconque des revendications précédentes,
**caractérisé en ce que**
les premier et deuxième capteurs d'approche (11, 14, 12, 16) sont sur une carte de circuits imprimés commune.

6. Dispositif selon l'une quelconque des revendications précédentes,
**caractérisé en ce qu'**
une alimentation en tension (18) est prévue pour alimenter la première et/ou la deuxième unité d'exploitation (14, 16).

7. Dispositif selon l'une quelconque des revendications précédentes,
**caractérisé en ce que**
les première et deuxième électrodes (11, 12), la première et/ou la deuxième unité d'exploitation (14, 16) et l'alimentation en tension (18) sont dans un boîtier (28, 30).

8. Dispositif selon l'une quelconque des revendications précédentes,
**caractérisé en ce que**
l'apparition du signal de demande de déverrouillage (20) et/ ou du signal de demande de fermeture (22) déclenche une interrogation d'autorisation avec un transpondeur (42) porté par l'utilisateur.

9. Dispositif selon l'une quelconque des revendications précédentes,
**caractérisé en ce que**
l'exploitation du signal de la première électrode (11) et/ou la génération d'un signal de demande de déverrouillage (22) ne s'effectue que si le système de fermeture (48) est verrouillé.

10. Dispositif selon l'une quelconque des revendications précédentes,
**caractérisé en ce qu'**
au moins un moyen de commutation (56) transmet soit le signal de sortie de la première électrode (11) soit le signal de sortie de la deuxième électrode (12) à une unité d'exploitation (58).

11. Dispositif selon l'une quelconque des revendications précédentes,
**caractérisé en ce que**
le moyen de commutation (56) est commandé en fonction de l'état du système de fermeture (48).

12. Dispositif selon l'une quelconque des revendications précédentes,
**caractérisé en ce que**
l'électrode de potentiel de référence (50) est disposée entre la première et/ou la deuxième électrode (11, 12) et une couche (62) électriquement conductrice de la poignée de portière extérieure (34).

13. Dispositif selon l'une quelconque des revendications précédentes,
**caractérisé en ce que**
les première et deuxième électrodes (11, 12) sont commandées de façon décalée dans le temps.

14. Dispositif selon l'une quelconque des revendications précédentes,
**caractérisé en ce que**
lors du déclenchement des première et deuxième électrodes (11, 12), seul le signal de l'électrode (11, 12) qui a été déclenché le premier est transmis.

15. Dispositif selon l'une quelconque des revendications précédentes,
**caractérisé en ce qu'**
un nouveau signal de l'électrode (11, 12) n'est transmis que si aucune approche n'a été reconnue au préalable par les deux électrodes (11, 12).
